# EUROPÄISCHE PATENTSCHRIFT

(11) **EP 1 347 310 B1**
(45) Veröffentlichungstag und Bekanntmachung des Hinweises auf die Patenterteilung: **02.11.2011**
(21) Anmeldenummer: 02027737.2
(22) Anmeldetag: 11.12.2002
(51) Int. Cl.: G01V 1/18, B06B 1/06, H03F 3/45

(54) **Unterwasserantenne mit mindestens einem Hydrofon und einer dem Hydrofon zugeordneten Verstärkungsschaltung**
Underwater antenna with at least one hydrophone and an amplifier-circuit associated with the hydrophone
Antenne sous-marine avec au moins un hydrophone et un circuit amplificateur associé a l'hydrophone

(30) Priorität: 20.03.2002 DE 10212291
(43) Veröffentlichungstag der Anmeldung: 24.09.2003
(73) Patentinhaber: ATLAS ELEKTRONIK GMBH, 28305 Bremen (DE)
(72) Erfinder: Krüger, Siegfried, 27243 Kirchseelte (DE); Wittschief, Norbert, 28832 Achim (DE)
(74) Vertreter: Wasiljeff, Johannes M.B.

(56) Entgegenhaltungen:
- DE-A- 3 940 198
- US-A- 3 221 296
- US-A- 4 241 428
- US-A- 4 516 228
- US-A- 5 625 320

## Beschreibung

Die Erfindung betrifft eine Unterwasserantenne der im Oberbegriff des Anspruchs 1 definierten Gattung.

Unterwasserantennen heutiger Bauweise zum Empfangen von Schall weisen eine Mehrzahl von als Hydrofone bezeichneten, elektroakustischen Wandlern auf, die zu einem Array zusammengefaßt sind. Unterwasserantennen bekannter Bauweise sind Zylinderbasen, Flank-Array, PRS-Basen, Interceptbasen etc. Den Hydrofonen ist eine Verstärkungsschaltung zur Verstärkung der elektrischen Ausgangssignale der Hydrofone nachgeschaltet.

Eine bekannte elektrische Verstärkungsschaltung (DE 100 47 396 A1, bzw. US 4 241 428 oder US 5 625 320) ist symmetrisch aufgebaut und weist zwei gleiche Ladungsverstärker auf, denen ein Spannungsverstärker mit in Stufen umschaltbarer Spannungsverstärkung nachgeschaltet ist. Die Ladungsverstärker sind mit ihren nichtinvertierenden Verstärkereingängen auf Nullpotential gelegt und mit ihren invertierenden Eingängen an das Hydrofon angeschlossen. Als Ladungsverstärker werden sog. geräuscharme Ladungsverstärker eingesetzt, wie sie beispielsweise von der Firma Analog Devices, www.analog.com, unter der Typenbezeichnung AD 745 angeboten werden. Ein solcher Ladungsverstärker weist eine hohe Ladungsempfindlichkeit und eine geringes Strom- und Spannungsrauschen auf und ist daher besonders für Hydrofone geeignet, die einen nur geringen Ladungsstrom liefern.

Der Erfindung liegt die Aufgabe zugrunde, eine Unterwasserantenne der eingangs genannten Art so zu modifizieren, daß die Möglichkeit gegeben ist, das Eigenrauschen der Ladungsverstärker in der Unterwasserantenne zu beeinflussen, um dieses reduzieren zu können.

Die Aufgabe ist erfindungsgemäß durch die Merkmale im Anspruch 1 gelöst.

Die erfindungsgemäße Unterwasserantenne hat den Vorteil, daß die Hydrofone einen auf Nullpotential oder Masse (Ground) liegenden Mittelanschluß zwischen zwei elektroakustischen Wandlerelementen aufweisen und damit die nachgeschalteten Ladungsverstärker einen gegen Nullpotential geschaltete Kapazität sehen. Dadurch läßt sich nunmehr jeder Ladungsverstärker durch Beschaltung der Verstärkereingänge mit einem entsprechend dimensionierten RC-Glied, das an die jeweilige Quellenimpedanz, also in diesem Fall an die Impedanz des angeschlossenen Wandlerelements, angepaßt ist, ausbalancieren. Ein ausbalancierter Ladungsverstärker hat im Gegensatz zu einem nicht ausbalancierten Ladungsverstärker insbesondere im Bereich kleiner Kapazitäten, wie sie Hydrofone aufweisen, ein nur geringes Spannungsrauschen.

Zweckmäßige Ausführungsformen der erfindungsgemäßen Unterwasserantenne mit vorteilhaften Weiterbildungen und Ausgestaltungen der Erfindung ergeben sich aus den weiteren Ansprüchen.

Gemäß einer bevorzugten Ausführungsform der Erfindung besteht jedes Wandlerelement des mindestens einen Hydrofons aus einer Kugelhalbschale aus radial polarisiertem, piezoelektrischem Material, deren innere und äußere Schalenflächen mit je einer Elektrode belegt sind. Die beiden Kugelhalbschalen sind gegensinnig polarisiert und längs ihres Schalenrands unter Zwischenlage einer elektrischen Isolierung zu einer Hohlkugel zusammengesetzt. Die beiden Außenelektroden der Kugelhalbschalen sind auf Nullpotential gelegt, und die beiden Innenelektroden der beiden Kugelhalbschalen sind über jeweils eine Zuleitung an je einem der Ladungsverstärker angeschlossen. Durch diesen konstruktiven Aufbau des Hydrofons aus zwei Kugelhalbschalen und der beschriebenen Verschaltung der Elektroden liegen die Außenelektroden der beiden Kugelhalbschalen auf Masse und bilden gleichzeitig eine Abschirmung des Hydrofons gegen elektrische Störstrahlungen in der Umgebung.

Um die Innenelektroden der beiden Kugelhalbschalen kontaktieren zu können, weist gemäß einer vorteilhaften Ausführungsform der Erfindung mindestens eine Halbkugelschale eine Radialbohrung auf, durch die hindurch die Zuleitungen zu den Innenelektroden geführt sind. Dabei können alternativ beiden Zuleitungen durch eine einzige Radialbohrung hindurchgeführt werden oder in jeder Kugelhalbschale eine Radialbohrung für eine Zuleitung vorgesehen werden.

Gemäß einer alternativen Ausführungsform der Erfindung wird für jedes elektroakustische Wandlerelement des Hydrofons eine Hohlkugel verwendet, die aus zwei Halbkugelschalen aus polarisiertem, piezoelektrischem Material unter Zwischenlage einer Isolierung zusammengesetzt ist und deren Schalenflächen innen und außen mit je einer Elektrode belegt sind. Sind die beiden Kugelhalbschalen gegensinnig polarisiert, so sind die beiden Innenelektroden in jeder Hohlkugel miteinander kontaktiert und eine Außenelektrode auf einer Kugelhalbschale der einen Hohlkugel und eine Außenelektrode auf der gegensinnig polarisierten Kugelhalbschale der anderen Hohlkugel zusammen auf Nullpotential oder Masse gelegt, während die verbleibenden Innen- und Außenelektroden auf den beiden Hohlkugeln an je einem der Verstärkereingänge der beiden Ladungsverstärker angeschlossen sind. Eine solche Ausführung der elektroakustischen Wandlerelemente des Hydrofons hat den Vorteil, daß Bohrungen in den Hohlkugeln zum Durchführen einer Zuleitung zu den Innenelektroden vermieden werden. Durch die dadurch erhaltene Reihenschaltung von zwei jeweils zwei Kugelhalbschalen aufweisenden, elektroakustischen Wandlerelementen hat das Hydrofon zwar nur eine halb so große Kapazität wie das durch eine einzige Hohlkugel mit zwei Kugelhalbschalen gebildete Hydrofon, weist aber dafür vorteilhaft eine höhere Spannungsempfindlichkeit auf. Durch das erfindungsgemäß mögliche Ausbalancieren der Ladungsverstärker hat aber die verkleinerte Kapazität keine Auswirkung auf dessen Strom- und Spannungsrauschen.

Gemäß einer alternativen Ausführungsform der Erfindung wird für jedes elektroakustische Wandlerelement des Hydrofons eine Hohlkugel verwendet, die aus zwei Halbkugelschalen aus polarisiertem, piezoelektrischem Material unter Zwischenlage einer Isolierung zusammengesetzt ist und deren Schalenflächen innen und außen mit je einer Elektrode belegt sind. Die beiden Kugelhalbschalen sind gleichsinnig polarisiert und die Außenelektroden der beiden Hohlkugeln auf Nullpotential gelegt, während die Innenelektroden der einen Hohlkugel und die Innenelektrode der anderen Hohlkugel an je einem der beiden Ladungsverstärker angeschlossen sind. Durch die dadurch erhaltene Parallelschaltung von zwei jeweils zwei Kugelhalbschalen aufweisenden, elektroakustischen Wandlerelementen hat dieses Hydrofon eine doppelt so große Kapazität wie das durch eine einzige Hohlkugel mit zwei Kugelhalbschalen gebildete Hydrofon und ist zudem noch durch die auf Masse liegenden Außenelektroden der Hohlkugeln gegen elektrische Störstrahlungen in der Umgebung abgeschirmt. Allerdings muß in jeweils einer Halbschale der beiden Hohlkugeln eine Bohrung zum Durchführen einer Anschlußleitung zu den beiden Innenelektroden vorgesehen werden.

Die Erfindung ist anhand von in der Zeichnung dargestellten Ausführungsbeispielen im folgenden näher beschrieben. Es zeigen:
- Fig. 1: ein Schaltbild einer Schaltungsanordnung eines Hydrofons mit einer diesem zugeordneten symmetrischen, elektrischen Verstärkungsschaltung,
- Fig. 2: ein Querschnitt des Hydrofons in Fig. 1, schematisch dargestellt,
- Fig. 3: einen Querschnitt eines modifizierten Hydrofons in Fig. 1, schematisch dargestellt,
- Fig. 4: eine Ersatzschaltbild der Hydrofone in Fig. 2 und 3,
- Fig. 5: einen Querschnitt eines Hydrofons in Fig. 1 gemäß einem weiteren Ausführungsbeispiel,
- Fig. 6: ein Ersatzschaltbild des Hydrofons in Fig. 5,
- Fig. 7: eine gleiche Darstellung wie in Fig. 5 mit einer Modifizierung des Hydrofons in Fig. 5,
- Fig. 8: ein Ersatzschaltbild des Hydrofons in Fig. 7,
- Fig. 9: eine gleiche Darstellung wie in Fig. 7 mit einer weiteren Modifizierung des Hydrofons.

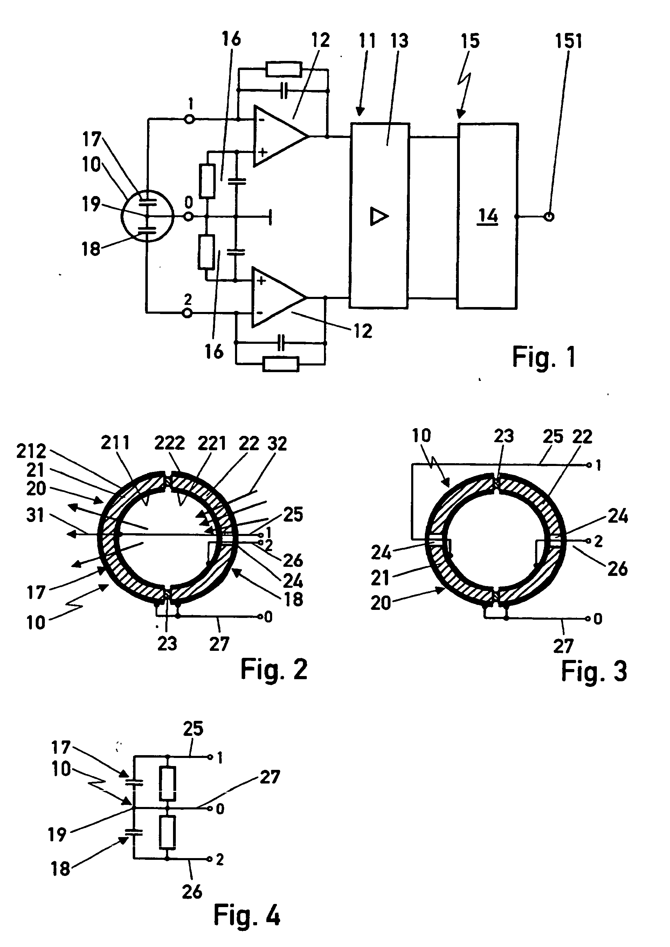

Die hier als Empfangsantenne eingesetzte Unterwasserantenne besitzt eine Vielzahl von als Hydrofone 10 bezeichneten elektroakustischen Wandlern, von denen in Fig. 1 nur eines dargestellt ist. Jedem Hydrofon 10 ist eine symmetrische, elektrische Verstärkungsschaltung 11 zugeordnet, die zwei gleiche Ladungsverstärker 12 mit je einem invertierenden und nichtinvertierenden Verstärkereingang und einen Spannungsverstärker 13 mit in Stufen umschaltbarer Spannungsverstärkung aufweist. An dem Ausgang des Spannungsverstärkers 13 ist ein Digitalisierungsblock 14 angeschlossen, der Analog/Digital-Wandler und diesen vorgeschaltete Anpaßverstärker enthält. Die Verstärkungsschaltung 11 und der Digitalisierungsblock 14 bilden einen sog. Hydrofonkanal 15, an dessen Ausgang 151 das verstärkte und digitalisierte Ausgangssignal des Hydrofons 10 zwecks Zuführung zu einer Signalverarbeitungseinheit abgenommen werden kann. Die Bauelemente des Hydrofonkanals 15 sind auf einer Leiterplatte angeordnet, die in einem Gehäuse aufgenommen ist, das zusammen mit dem Hydrofon 10 in der Unterwasserantenne vergossen ist.

Die beiden nichtinvertierenden Verstärkereingänge der beiden Ladungsverstärker 12 sind über je ein RC-Glied 16 auf Nullpotential oder Masse (Ground) gelegt, und die beiden invertierenden Eingänge sind an dem Hydrofon 10 angeschlossen. Die Ladungsverstärker 12 sind identisch ausgebildet und weisen die gleiche Verstärkung auf. Zur Realisierung der Ladungsverstärker werden entsprechend beschaltete Operationsverstärker des Typs AD 745 der Firma Analog Devices, www.analog.com, mit entsprechender Auslegung des Rückkopplungszweigs verwendet.

Das in Fig. 2 schematisch im Querschnitt dargestellte Hydrofon 10 weist zwei Kugelhalbschalen 21, 22 aus radial polarisiertem, piezoelektrischem Material auf, die zu einer Hohlkugel 20 zusammengesetzt sind. Zwischen den aneinanderstoßenden, kreisringförmigen Stirnflächen der beiden Kugelhalbschalen 21, 22 ist ein elektrischer Isolationsring 23 angeordnet. Die inneren und äußeren Schalenflächen der beiden Kugelhalbschalen 21, 22 sind mit je einer Elektrode belegt. So weist gemäß Fig. 2 die Kugelhalbschale 21 die Innenelektrode 211 und die Außenelektrode 212 und die Kugelhalbschale 22 die Innenelektrode 221 und die Außenelektrode 222 auf. Die Polarisierung der Kugelhalbschalen 21, 22 ist gegensinnig, so daß beispielsweise die Polarisierungsrichtung der Kugelhalbschale 21 von innen nach außen und die Polarisierung der Kugelhalbschale 22 von außen nach innen verläuft, wie dies durch die Pfeile 31 bzw. 32 in Fig. 2 angedeutet ist. Jede dieser Kugelhalbschalen 21, 22 bildet ein elektronisches Wandlerelement 17 bzw. 18, dessen elektrisches Ersatzschaltbild in Fig. 4 dargestellt ist. Die beiden Wandlerelemente 17, 18 sind in Reihe geschaltet, wie dies aus dem Ersatzschaltbild in Fig. 4 hervorgeht, und die elektrische Verbindung 19 zwischen den beiden Wandlerelementen 17, 18 ist an Nullpotential oder Masse (Ground) gelegt.

Um bei der Hohlkugel 20 gemäß Fig. 2 die Anschlüsse an den Innenelektroden 221, 222 zu realisieren, ist in die Kugelhalbschale 22 eine Radialbohrung 24 eingebracht, durch die hindurch zwei Anschlußleitungen 25, 26 zu je einer der Innenelektroden 211 und 221 der Kugelhalbschalen 21 und 22 hindurchgeführt sind. Die Anschlußleitungen 25 und 26 sind mit den Anschlußklemmen 1 und 2 des Hydrofons 10, die mit den beiden Ladungsverstärkern 12 zu verbinden sind, belegt. Die beiden Außenelektroden 212 und 222 der beiden Kugelhalbschalen 21, 22 sind miteinander verbunden und über eine Anschlußleitung 27 an den Mittenanschluß 0 des Hydrofons 10 gelegt, der auf das Nullpotential oder Masse gelegt wird. Selbstverständlich ist es auch möglich, die beiden Außenelektroden 212 und 222 der beiden Kugelhalbschalen 21, 22 an je eine der Anschlußklemmen 1 und 2 anzuschließen und die beiden Innenelektroden 211 und 221 mit dem Mittenanschluß 0 zu verbinden. Die erstgenannte Verschaltung hat aber den Vorteil, daß die beiden Außenelektroden 212 und 222 der Hohlkugel 20 auf Masse liegen und damit eine Abschirmung des Hydrofons 10 gegenüber elektrischen Störstrahlungen aus der Umgebung bilden.

Durch geeignete Auslegung der RC-Glieder 16 an den nicht invertierenden Eingängen der Ladungsverstärker 12, die nunmehr einzeln und ohne gegenseitige Beeinflussung an die Impedanz des zugeordneten Wandlerelements 17 bzw. 18 angepaßt werden können, können die Ladungsverstärker 12 ausbalanciert werden, wodurch ihr Spannungs- und Stromrauschen, das bei nicht ausbalancierten Ladungsverstärkern aufgrund der kleinen Kapazitäten des Hydrofons 10 relativ groß ist, erheblich reduziert wird, und zwar auf einen Betrag, den der nicht ausbalancierte Ladungsverstärker nur bei etwa einhundertmal größerer Eingangskapazität aufweist.

Das in Fig. 3 schematisch im Querschnitt skizzierte Hydrofon 10, das wiederum aus zwei Wandlerelementen 17, 18 zusammengesetzt ist, weist den gleichen hohlkugelförmigen Aufbau auf wie das Hydrofon gemäß Fig. 2. Es unterscheidet sich lediglich dadurch, daß auch in der Kugelhalbschale 21 eine gleiche Radialbohrung 24 wie in der Kugelhalbschale vorgesehen ist. Die beiden die Innenelektroden 211 und 221 an die Anschlußklemmen 1 und 2 anlegenden Anschlußleitungen 25, 26 sind jeweils durch eine der beiden Radialbohrungen 24 hindurchgeführt. Im übrigen stimmt der Aufbau der Hohlkugel 20 in Fig. 3 mit dem der Hohlkugel 20 in Fig. 2 überein, so daß gleiche Bauteile mit gleichen Bezugszeichen gekennzeichnet sind.

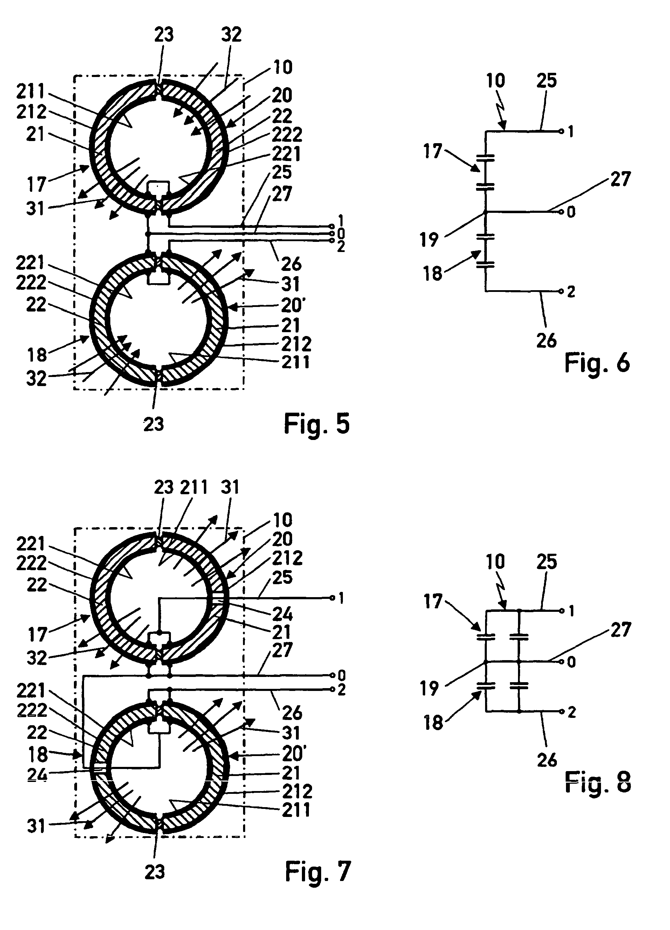

Bei dem in Fig. 5 im Querschnitt schematisch dargestellten Hydrofon 10 ist jedes Wandlerelement 17 von einer Hohlkugel 20 bzw. 20' gebildet, wie sie bereits in Verbindung mit Fig. 2 beschrieben worden ist. Das Ersatzschaltbild des Hydrofons 10 gemäß Fig. 5 ist in Fig. 6 dargestellt, wobei auf die Darstellung der ebenfalls vorhandenen Ohmschen Widerstände verzichtet worden ist. Jedes elektroakustische Wandlerelement 17, 18 des Hydrofons 10 weist danach eine Reihenschaltung von zwei Kapazitäten auf, die wiederum in Reihe geschaltet sind. Die Kapazität des Hydrofons 10 gemäß Fig. 5 beträgt damit nur noch die Hälfte der Kapazität des Hydrofons 10 gemäß Fig. 2. In jeder Hohlkugel 20 bzw. 20' sind die Innenelektroden 211 und 221 der beiden Kugelhalbschalen 21, 22 elektrisch miteinander kontaktiert. Von den Außenelektroden 212 und 222 in den beiden Hohlkugeln 20, 20' ist die eine Außenelektrode 212 auf einer Kugelhalbschale 21 der einen Hohlkugel 20 zusammen mit der Außenelektrode 222 auf der Kugelhalbschale 22 mit dazu inverser Polarisationsrichtung der anderen Hohlkugel 20' über die Anschlußleitung 27 an den Mittenanschluß 0 gelegt, während von den beiden verbleibenden Außenelektroden 222 der einen Hohlkugel 20 und 212 der anderen Hohlkugel 20' je eine über die Anschlußleitung 25 bzw. 26 mit der Anschlußklemme 1 bzw. der Anschlußklemme 2 kontaktiert ist. Dieser Aufbau des Hydrofons 10 hat den Vorteil, daß Radialbohrungen in den Kugelhalbschalen 21, 22 der Hohlkugeln 20, 20' entfallen.

Das in Fig. 7 dargestellte Hydrofon 10 besteht - ebenso wie das Hydrofon 10 gemäß Fig. 5 - aus zwei Hohlkugeln 20, 20', von denen jede aus zwei Kugelhalbschalen 21, 22 aus radial polarisiertem, piezoelektrischem Material zusammengesetzt ist, wobei zwischen den Stoßstellen der beiden Kugelhalbschalen 21, 22 wiederum der Isolationsring 23 einliegt. Die radiale Polarisation der Kugelhalbschalen 21, 22 ist gleichsinnig. Die beiden Innenelektroden 211 und 221 der einen Hohlkugel 20 sind miteinander kontaktiert und über die Anschlußleitung 25, die durch eine Radialbohrung 24 in der Halbschale 22 hindurchgeführt ist, an die Anschlußklemme 1 des Hydrofons 10 gelegt. Die beiden Außenelektroden 212 und 222 der anderen Hohlkugel 20' sind gemeinsam über die Anschlußleitung 26 mit der Anschlußklemme 2 des Hydrofons 10 kontaktiert. Die verbleibenden beiden Innenelektroden 211, 221 der einen Hohlkugel 20 sind über die Anschlußleitung 27, die durch eine Radialbohrung 24 in der Kugelhalbschale 22 hindurchgeführt ist, an den Mittenanschluß 0 gelegt. Mit dieser Anschlußleitung 27 sind auch die beiden verbleibenden Außenelektroden 212 und 222 der andere Hohlkugel 20' verbunden. Das Ersatzschaltbild dieses Hydrofons 10 ist in Fig. 8 dargestellt, wobei wiederum auf die vorhandenen Ohmschen Widerstände verzichtet wurde. In jedem elektroakustischen Wandlerelement 17 bzw. 18 des Hydrofons 10 sind die Kapazitäten der beiden Kugelhalbschalen 21, 22 parallelgeschaltet. Die Kapazitäten der beiden Hohlkugeln 20, 20' sind in Reihe geschaltet. Das Hydrofon 10 gemäß Fig. 7 hat damit die doppelte Kapazität des Hydrofons 10 gemäß Fig. 2.

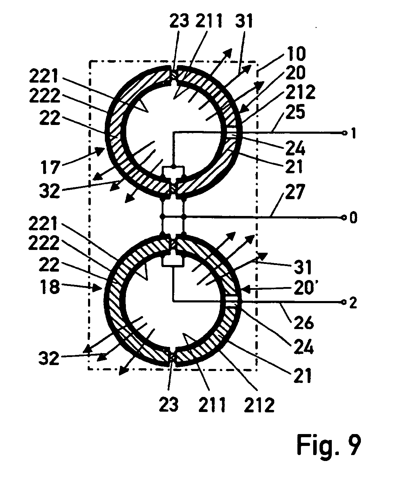

Das in Fig. 9 schematisiert dargestellte Hydrofon 10 entspricht im Aufbau dem Hydrofon 10 in Fig. 7, jedoch sind die Innenelektroden 211 und 221 und die Außenelektroden 212 und 222 der beiden Hohlkugeln 20, 20' anders belegt. So sind die Außenelektroden 212 und 222 der beiden Hohlkugeln 20, 20' über die Anschlußleitung 27 an den Mittenanschluß 0 gelegt, während die beiden Innenelektroden 211 und 221 der Hohlkugel 20 über die Anschlußleitung 25 mit der Anschlußklemme 1 und der Hohlkugel 20' über die Anschlußleitung 26 mit der Anschlußklemme 2 des Hydrofons 10 kontaktiert sind. Dies hat den Vorteil, daß die Außenelektroden 212 und 222 beider Hohlkugeln 20, 20' auf Masse liegen und dadurch das Hydrofon 10 wieder abgeschirmt ist. Das elektrische Ersatzschaltbild dieses Hydrofons 10 entspricht Fig. 8.

Die Erfindung ist nicht auf das beschriebene Ausführungsbeispiel beschränkt. So kann das Hydrofon 10 auch an die nichtinvertierenden Verstärkereingänge der beiden Ladungsverstärker 12 angeschlossen werden, deren invertierende Eingänge mit einer entsprechenden RC-Beschaltung zum Ausbalancieren der Ladungsverstärker 12 an dem Nullpotential liegen. Auch ist es nicht zwingend, die elektroakustischen Wandlerelemente als Halbschalen aus piezoelektrischem Material auszubilden und zwei Wandlerelemente zu einer Hohlkugel zusammenzusetzen. Die Wandlerelemente können auch als Vollzylinder oder Quader gefertigt werden, auf deren voneinander abgekehrten Stirnflächen jeweils eine Elektrode aufgebracht ist.

## Patentansprüche

1. Unterwasserantenne mit mindestens einem Hydrofon (10) und einer dem Hydrofon (10) zugeordneten, symmetrischen, elektrischen Verstärkungsschaltung (11), die zwei gleiche Ladungsverstärker (12) mit je einem invertierenden und nichtinvertierenden Verstärkereingang aufweiset, von denen zwei gleichartige Verstärkereingänge an Nullpotential und zwei gleichartige Verstärkereingäne an dem Hydrofon (10) angeschlossen sind, **dadurch gekennzeichnet, daß** das Hydrofon (10) zwei in Reihe geschaltete, elektroakustische Wandlerelemente (17, 18) aufweist und daß die Verbindung (19) zwischen den Wandlerelementen (17, 18) auf Nullpotential gelegt ist.

2. Unterwasserantenne nach Anspruch 1, **dadurch gekennzeichnet, daß** zwischen jedem der an Nullpotential angeschlossenen Verstärkereingänge der Ladungsverstärker (12) und dem Nullpotential ein RC-Glied (16) zum Ausbalancieren eines jeden der beiden Ladungsverstärker (12) angeordnet ist.

3. Unterwasserantenne nach Anspruch 1 oder 2, **dadurch gekennzeichnet, daß** die elektroakustischen Wandlerelemente (17, 18) des mindestens einen Hydrofons (10) eine zumindest annähernd gleiche Kapazität aufweisen.

4. Unterwasserantenne nach einem der Ansprüche 1 - 3, **dadurch gekennzeichnet, daß** jedes elektroakustische Wandlerelement (17, 18) des mindestens einen Hydrofons (10) aus einer Kugelhalbschale (21, 22) aus radial polarisiertem, piezoelektrischem Material besteht, deren innere und äußere Schalenflächen mit je einer Elektrode (211,212, 221, 222) belegt sind, daß die beiden Kugelhalbschalen (21, 22) gegensinnig polarisiert und längs ihrer Schalenräder unter Zwischenlage einer elektrischen Isolierung (23) zu einer Hohlkugel (20) zusammengesetzt sind und daß die beiden Außenelektroden (212, 222) der Kugelhalbschalen (21, 22) auf Nullpotential gelegt sind und die beiden Innenelektroden (211, 221) der Kugelhalbschalen (21, 22) über jeweils eine Anschlußleitung (25, 26) an je einem der Ladungsverstärker (12) angeschlossen sind.

5. Unterwasserantenne nach Anspruch 4, **dadurch gekennzeichnet, daß** die Anschlußleitungen (25, 26) durch eine Radialbohrung (24) in einer der Kugelhalbschalen (22) hindurchgeführt sind.

6. Unterwasserantenne nach Anspruch 4, **dadurch gekennzeichnet, daß** jede der beiden Kugelhalbschalen (21, 22) eine Radialbohrung (24) aufweist und daß die Zuleitungen (25, 26) zu den Innenelektroden (211, 212) durch mindestens eine der Radialbohrungen (24) hindurchgeführt sind.

7. Unterwasserantenne nach einem der Ansprüche 1 - 3, **dadurch gekennzeichnet, daß** jedes elektroakustische Wandlerelement (17, 18) des mindestens einen Hydrofons (10) von einer aus zwei Kugelhalbschalen (21, 22) mit einer dazwischenliegenden, elektrischen Isolierung (23) zusammengesetzten Hohlkugel (20, 20') gebildet ist und daß die Kugelhalbschalen (21, 22) einer jeden Hohlkugel (20, 20") aus radial polarisiertem, piezoelektrischem Material bestehen und auf den inneren und äußeren Schalenflächen der Kugelhalbschalen (21, 22) mit je einer Elektrode (211, 212, 221, 222) belegt sind.

8. Unterwasserantenne nach Anspruch 7, **dadurch gekennzeichnet, daß** die beiden Kugelhalbschalen (21, 22) einer jeder Hohlkugel (20, 20') gegensinnig polarisiert sind, daß die beiden Innenelektroden (211, 221) in jeder Hohlkugel (20, 20') miteinander kontaktiert sind, daß eine Außenelektrode (212) auf einer Kugelhalbschale (21) der einen Hohlkugel (20) und eine Außenelektrode (222) auf der gegensinnig polarisierten Kugelhalbschale (22) der anderen Hohlkugel (20') auf Nullpotential gelegt sind und daß die verbleibenden beiden Außenelektroden (222, 212) der beiden Hohlkugeln (20, 20') an je einem der Ladungsverstärker (12) angeschlossen sind.

9. Unterwasserantenne nach Anspruch 7, **dadurch gekennzeichnet, daß** die beiden Kugelhalbschalen (21, 22) einer jeden Hohlkugel (20, 20') gleichsinnig polarisiert sind, daß die Außenelektroden (212, 222) der einen Hohlkugel (20) zusammen mit den Innenelektroden (211, 221) der anderen Hohlkugel (20') auf Nullpotential gelegt sind und daß die verbleibenden Außenelektroden (212, 222) der einen Hohlkugel (20) und die verbleibenden Innenelektroden (211, 221) der anderen Hohlkugel (20') an je einem der beiden Ladungsverstärker (12) angeschlossen sind.

10. Unterwasserantenne nach Anspruch 9, **dadurch gekennzeichnet, daß** die beiden Innenelektroden (211, 221) einer jeden Hohlkugel (20,20') miteinander verbunden und über eine durch eine Radialbohrung (24) hindurchgeführte Anschlußleitung (25, 27) von außen kontaktierbar sind.

11. Unterwasserantenne nach Anspruch 7, **dadurch gekennzeichnet, daß** die beiden Kugelhalbschalen (21, 22) einer jeden Hohlkugel (20, 20') gleichsinnig polarisiert sind und daß die Außenelektroden (212, 222) beider Hohlkugeln (20, 20') auf Nullpotential gelegt und die Innenelektroden (211, 221) der einen Hohlkugel (20) und die Innenelektroden (211, 221) der anderen Hohlkugel (20') an je einem der Ladungsverstärker (12) angeschlossen sind.

12. Unterwasserantenne nach einem der Ansprüche 1 - 11, **dadurch gekennzeichnet, daß** das Hydrofon (10) an den invertierenden Verstärkereingängen der Ladungsverstärker (12) angeschlossen ist.

## Claims

1. Underwater antenna with at least one hydrophone (10) and a symmetrical electrical amplifier circuit (11), associated with the hydrophone (10), which has two identical charge amplifiers (12) having in each case one inverting and non-inverting amplifier input of which two similar amplifier inputs are connected to zero potential and two similar amplifier inputs are connected to the hydrophone (10), **characterized in that** the hydrophone (10) has two series-connected electroacoustic transducer elements (17, 18) and **in that** the connection (19) between the transducer elements (17, 18) is placed at zero potential.

2. Underwater antenna according to Claim 1, **characterized in that** between each of the amplifier inputs, connected to zero potential, of the charge amplifiers (12) and the zero potential, an RC element (16) for balancing out each of the two charge amplifiers (12) is arranged.

3. Underwater antenna according to Claim 1 or 2, **characterized in that** the electroacoustic transducer elements (17, 18) of the at least one hydrophone (10) have an at least approximately equal capacity.

4. Underwater antenna according to one of Claims 1 - 3, **characterized in that** each electroacoustic transducer element (17, 18) of the at least one hydrophone (10) consists of a spherical half shell (21, 22) of radially polarized piezoelectric material, the internal and external shell faces of which are occupied with one electrode (211, 212, 221, 222) each, **in that** the two spherical half shells (21, 22) are polarized in the opposite direction and are assembled along their shell edges with interposition of an electric insulation (23) to form a hollow sphere (20), and **in that** the two external electrodes (212, 222) of the spherical half shells (21, 22) are placed at zero potential and the two internal electrodes (211, 221) of the spherical half shells (21, 22) are connected to any one of the charge amplifiers (12) each by in each case one connecting line (25, 26).

5. Underwater antenna according to Claim 4, **characterized in that** the connecting lines (25, 26) are passed through a radial hole (24) in one of the circle half shells (22).

6. Underwater antenna according to Claim 4, **characterized in that** each of the two spherical half shells (21, 22) has a radial hole (24) and **in that** the feed lines (25, 26) to the internal electrodes (211, 212) are passed through at least one of the radial holes (24).

7. Underwater antenna according to one of Claims 1 - 3, **characterized in that** each electroacoustic transducer element (17, 18) of the at least one hydrophone (10) is formed by a hollow sphere (20, 20') assembled from two circle half shells (21, 22) with an intermediate electric insulation (23) and **in that** these spherical half shells (21, 22) of each hollow sphere (20, 20') consist of radially polarized piezoelectric material and are occupied by one electrode (211, 212, 221, 222) each on the internal and external shell faces of the spherical half shells (21, 22).

8. Underwater antenna according to Claim 7, **characterized in that** the two spherical half shells (21, 22) of each hollow sphere (20, 20') are polarized in opposite directions, **in that** the two internal electrodes (211, 221) are placed in contact with one another in each hollow sphere (20, 20'), **in that** an external electrode (212) on a spherical half shell (21) of one hollow sphere (20) and an external electrode (222) on the spherical half shell (22), polarized in the opposite direction, of the other hollow sphere (20') are placed at zero potential and **in that** the remaining two external electrodes (222, 212) of the two hollow spheres (20, 20') are connected to one of the charge amplifiers (12) each.

9. Underwater antenna according to Claim 7, **characterized in that** the two circle half shells (21, 22) of each hollow sphere (20, 20') are polarized in the same direction, and that the external electrodes (212, 222) of one hollow sphere (20), together with the internal electrodes (211, 221) of the other hollow sphere (20') are placed at zero potential and **in that** the remaining external electrodes (212, 222) of one hollow sphere (20) and the remaining internal electrodes (211, 221) of the other hollow sphere (20') are connected to one of the two charge amplifiers (12) each.

10. Underwater antenna according to Claim 9, **characterized in that** the two internal electrodes (211, 221) of each hollow sphere (20, 20') are connected to one another and can be contacted from the outside via a connecting line (25, 27) passed through a radial hole (24).

11. Underwater antenna according to Claim 7, **characterized in that** the two spherical half shells (21, 22) of each hollow sphere (20, 20') are polarized in the same direction and **in that** the external electrodes (212, 222) of both hollow spheres (20, 20') are placed at zero potential and the internal electrodes (211, 221) of one hollow sphere (20) and the internal electrodes (211, 221) of the other hollow sphere (20') are connected to one of the charge amplifiers (12) each.

12. Underwater antenna according to one of Claims 1 - 11, **characterized in that** the hydrophone (10) is connected to the inverting amplifier inputs of the charge amplifiers (12).

## Revendications

1. Antenne sous-marine comprenant au moins un hydrophone (10) et un circuit amplificateur (11) électrique symétrique associé à l'hydrophone (10), lequel présente deux amplificateurs de charge (12) identiques comprenant chacun une entrée d'amplificateur inverseuse et une non inverseuse, parmi lesquelles deux entrées d'amplificateur du même type sont raccordées au potentiel nul et deux entrées d'amplificateur du même type sont raccordées à l'hydrophone (10), **caractérisée en ce que** l'hydrophone (10) présente deux éléments convertisseurs électroacoustiques (17, 18) branchés en série et **en ce que** la liaison (19) entre les éléments convertisseurs (17, 18) est mise au potentiel nul.

2. Antenne sous-marine selon la revendication 1, **caractérisée en ce qu'**un réseau RC (16) destiné à équilibrer chacun des deux amplificateurs de charge (12) est disposé entre chacune des entrées d'amplificateur raccordées au potentiel nul des amplificateurs de charge (12) et le potentiel nul.

3. Antenne sous-marine selon la revendication 1 ou 2, **caractérisée en ce que** les éléments convertisseurs électroacoustiques (17, 18) de l'au moins un hydrophone (10) présentent une capacité au moins approximativement identique.

4. Antenne sous-marine selon l'une des revendications 1 à 3, **caractérisée en ce que** chaque élément convertisseur électroacoustique (17, 18) de l'au moins un hydrophone (10) se compose d'une demi-coque sphérique (21, 22) en un matériau piézoélectrique polarisé dans le sens radial, dont les faces de coque intérieure et extérieure sont respectivement occupées par une électrode (211, 212, 221, 222), **en ce que** les deux demi-coques sphériques (21, 22) sont polarisées en sens inverse et sont assemblées le long de leurs bords latéraux en intercalant un isolant électrique (23) pour former une sphère creuse (20) et **en ce que** les deux électrodes extérieures (212, 222) des demi-coques sphériques (21, 22) sont mises au potentiel nul et les deux électrodes intérieures (211, 221) des demi-coques sphériques (21, 22) sont respectivement raccordées à l'un des amplificateurs de charge (12) à chaque fois par le biais d'une ligne de raccordement (25, 26).

5. Antenne sous-marine selon la revendication 4, **caractérisée en ce que** les lignes de raccordement (25, 26) pénètrent dans l'une des demi-coques sphériques (22) en passant à travers un orifice radial (24).

6. Antenne sous-marine selon la revendication 4, **caractérisée en ce que** chacune des deux demi-coques sphériques (21, 22) présente un orifice radial (24) et **en ce que** les lignes d'arrivée (25, 26) vers les électrodes intérieures (211, 212) entrent en passant à travers au moins l'un des orifices radiaux (24).

7. Antenne sous-marine selon l'une des revendications 1 à 3, **caractérisée en ce que** chaque élément convertisseur électroacoustique (17, 18) de l'au moins un hydrophone (10) est formé par une sphère creuse (20, 20') assemblée à partir de deux demi-coques sphériques (21, 22) entre lesquelles se trouve un isolant électrique (23) et **en ce que** les demi-coques sphériques (21, 22) de chaque sphère creuse (20, 20') se composent d'un matériau piézoélectrique polarisé dans le sens radial et sont respectivement occupées par une électrode (211, 212, 221, 222) sur les faces de coque intérieure et extérieure des demi-coques sphériques (21, 22).

8. Antenne sous-marine selon la revendication 7, **caractérisée en ce que** les deux demi-coques sphériques (21, 22) de chaque sphère creuse (20, 20') sont polarisées en sens inverse, **en ce que** les deux électrodes intérieures (211, 221) dans chaque sphère creuse (20, 20') sont en contact entre elles, **en ce qu'**une électrode extérieure (212) sur une demi-coque sphérique (21) de l'une des sphères creuses (20) et une électrode extérieure (222) sur la demi-coque sphérique (22) polarisée en sens inverse de l'autre sphère creuse (20') sont mises au potentiel nul et **en ce que** les deux électrodes extérieures (222, 212) restantes des deux sphères creuses (20, 20') sont respectivement raccordées à l'un des amplificateurs de charge (12).

9. Antenne sous-marine selon la revendication 7, **caractérisée en ce que** les deux demi-coques sphériques (21, 22) de chaque sphère creuse (20, 20') sont polarisées dans le même sens, **en ce que** les électrodes extérieures (212, 222) de l'une des sphères creuses (20) ainsi que les électrodes intérieures (211, 221) de l'autre sphère creuse (20') sont mises au potentiel nul et **en ce que** les électrodes extérieures (212, 222) restantes de l'une des sphères creuses (20) et les électrodes intérieures (211, 221) restantes de l'autre sphère creuse (20') sont respectivement raccordées à l'un des deux amplificateurs de charge (12).

10. Antenne sous-marine selon la revendication 9, **caractérisée en ce que** les deux électrodes intérieures (211, 221) de chacune des sphères creuses (20, 20') sont reliées entre elles et le contact avec celles-ci depuis l'extérieur peut être établi par le biais d'une ligne de raccordement (25, 27) qui entre en passant à travers un orifice radial (24).

11. Antenne sous-marine selon la revendication 7, **caractérisée en ce que** les deux demi-coques sphériques (21, 22) de chaque sphère creuse (20, 20') sont polarisées dans le même sens et **en ce que** les électrodes extérieures (212, 222) des deux sphères creuses (20, 20') sont mises au potentiel nul et les électrodes intérieures (211, 221) de l'une des sphères creuses (20) et les électrodes intérieures (211, 221) de l'autre sphère creuse (20') sont respectivement raccordées à l'un des amplificateurs de charge (12).

12. Antenne sous-marine selon l'une des revendications 1 à 11, **caractérisée en ce que** l'hydrophone (10) est raccordé aux entrées d'amplificateur inverseuses des amplificateurs de charge (12).
